# EUROPEAN PATENT APPLICATION

(11) **EP 4 530 616 A1**
(43) Date of publication of application: **02.04.2025**
(21) Application number: 23201089.2
(22) Date of filing: 29.09.2023
(51) Int. Cl.: G01N 23/2251

(54) **METHODS AND SYSTEMS OF ELECTRON DIFFRACTION**

(71) Applicant: FEI Company, Hillsboro, OR 97124 (US)
(72) Inventor: HOLZER, Jakub, Brno (CZ); STEPHENS, Chris, Altrincham (GB); VYSTAVEL, Tomas, Brno (CZ); STRAKA, Branislav, Brno (CZ)
(74) Representative: Boult Wade Tennant LLP

(57) **Abstract**

A method of producing an electron diffraction pattern comprises of directing an electron beam to be incident upon a sample and detecting, by a particle detector with an array of pixels, electrons scattered from the sample. The detecting comprises, for each detected electron at a pixel, measuring an energy value that is proportional to the energy of the detected electron. The measured energy value of each detected electron and an identifier of the pixel that detected the electron are sent to a processing device. An energy-weighted contribution value from each measured energy value is calculated by the processing device using an energy-dependent function. The energy-dependent function produces energy-weighted contribution values that vary with electron energy. An energy-weighted electron diffraction pattern is then generated using pixel positions associated with each pixel identifier, and the energy-weighted contribution values.

## Description

### FIELD OF THE INVENTION

The present invention relates to methods and systems of electron diffraction. In particular, to methods and systems of energy-weighted electron diffraction.

### BACKGROUND

Electrons incident on a sample interact with atoms within the sample, causing some of the electrons to be scattered off the sample at varying angles. Some electrons are backscattered by the atoms. When the sample is crystalline or polycrystalline, electrons can be diffracted in accordance with Bragg's law which depends on the electrons' energy, the angle of incidence relative to the crystal planes and the spacing of the crystal planes. Electrons scattered from the sample, including the diffracted electrons, can be detected using a particle detector. The signal provided by the detector may be processed to produce electron backscatter diffraction (EBSD) patterns that may be used to characterise the sample structure. The diffraction patterns are seen as a series of lines forming Kikuchi bands which provide information about the sample's crystal lattice and orientation in space. The relationships between diffraction patterns for a sample can be analysed to determine further information about the sample, for example, the grain size and texture, phase distribution, and strain.

Conventional electronic particle detectors may operate in a 'counting' mode, where the number of electrons incident on a pixel across a time window is counted. Conventional particle detectors may also use a predetermined energy threshold such that only electrons above the threshold are counted and electrons below the threshold are discarded. Electrons counted for each pixel are provided in a single-frame readout of all pixels which are then used for diffraction pattern processing. For example, the number of electrons counted may be mapped to a display value, such as colour or greyscale value, and an image presented that maps the display values to pixel positions within the image.

In one example, US patent no. 8 890 065 describes an apparatus for detecting one or each of Kikuchi and Kossel diffraction patterns. The apparatus comprises an electron column adapted in use to provide an electron beam directed towards a sample, the electron beam having an energy in the range 2 keV to 50 keV. The apparatus also comprises a particle detector for receiving and counting electrons from the sample due to interaction of the electron beam with the sample. The detector comprises an array of pixels and has a count rate capability to deal with at least 1000 electrons per second for each pixel. The particle detector is adapted to provide electronic energy filtering of the received electrons in order to count only the received particles which are representative of the diffraction pattern.

The particle detectors described above operate cumulatively where the number of electron strikes across a time frame are summed before being read out. Other particle detectors may operate in a data-driven mode, where electron data are readout every time the detector records an electron strike. For example, European patent publication no. EP3761016 describes a method for imaging a sample, comprising repetitively scanning a region of interest, ROI, of the sample by directing a charged particle beam towards multiple impact points of the ROI and detecting particles scattered from the multiple impact points, during the repetitive scan, calculating a signal quality of each impact point of the multiple impact points, and updating a signal quality of the ROI based on the signal quality of each impact point after each single scan of the ROI, wherein the signal quality of a particular impact point is calculated based on the detected particles scattered from the impact point, terminating the repetitive scan responsive to the signal quality of the ROI higher than a threshold signal quality, and forming a structural image of the ROI based on the detected particles during the repetitive scan.

In electron diffraction, the higher energy electrons usually provide the most information about a sample. However, it can be beneficial also to make use of the full electron energy spectrum, for example to improve signal-to-noise statistics. Conventional electron diffraction methods may apply a set energy threshold to accept only electrons above/below the threshold. However, this results in the loss of information from electrons with an energy that doesn't meet the threshold.

### SUMMARY

In a first aspect, there is a method of producing an electron diffraction pattern. The method comprises directing an electron beam to be incident upon a sample, and detecting, by a particle detector with an array of pixels, electrons scattered from the sample. The detecting comprises, for each detected electron at a pixel, measuring an energy value that is proportional to the energy of the detected electron. For example, measuring the energy value may comprise measuring the time that the charge induced in a pixel struck by an electron is above a detector threshold level. This measured time is proportional to the induced charge in the pixel, and so is also proportional to the actual energy of the detected electron measured by the particle detector.

The method further comprises sending the measured energy value of each detected electron and an identifier of the pixel that detected the electron to a processing device. These measured energy values are sent each and every time an electron strikes the pixel array so that information about the electron's energy is provided in real time to the processing device. The pixel identifier is an identifier from which the processing device can determine the position within the pixel array at which an electron was detected. For example, the identifier may identify the pixel position within the array of pixels where that electron was detected.

The method further comprises calculating, by the processing device, an energy weighted contribution value from each measure energy value using an energy-dependent function. The energy-dependent function varies with electron energy and so the contribution each detected electron makes is dependent upon its energy. As such, electron energy can be used as an additional discrimination parameter in producing diffraction patterns.

The method further comprises generating, by the processing device, an energy-weighted electron diffraction pattern using pixel positions associated with each pixel identifier, and the energy-weighted contribution values.

Because the energy-dependent function varies with electron energy, the energy-dependent function may increase or decrease the contribution of a detected electron to the generated electron diffraction pattern dependent on the energy of that detected electron. For example, the energy-dependent function may increase the contribution of higher energy detected electrons relative to lower energy detected electrons. The energy-weighted contribution value may be higher for a detected electron than the energy-weighted contribution energy values for all detected electrons with a lower energy. The energy-dependent function may produce energy-weighted contribution values that increase with increasing energy values. For example, the energy-dependent function may produce energy-weighted contribution values that increase linearly with increasing electron energy values. The energy-dependent function may also be user settable.

As part of the method, the detecting step may further comprise, for each detected electron, measuring the detection time of the detected electron. The detection time may be the time of arrival of the electron at a pixel, or it may be the time the signal is sent to the processing device. The sending step may further comprise sending the measured detection time of the detected electron to the processing device. The measured detection times can then be used in the generation of the energy-weighted electron diffraction pattern.

Generating the energy-weighted electron diffraction pattern using the pixel positions and the energy-weighted contribution values may comprise generating an energy-weighted electron diffraction pattern comprising an array of image pixels arranged to conform to the array of pixels of the particle detector. Each image pixel is displayed with a display value proportional to a combination of the energy-weighted contribution values of the electrons detected to have struck the corresponding pixel of the particle detector. For example, the display value may be the sum of all of the energy-weighted contribution values of the electrons detected to have struck the corresponding pixel of the particle detector.

The generated energy-weighted electron diffraction pattern may be a colour image and the display values are values on a colour gradient, or the generated energy-weighted electron diffraction pattern may be a grayscale image and the display values are intensities.

The quality of the generated energy-weighted electron diffraction pattern is affected by background signal. To improve the quality, the method may further comprise performing a background subtraction by detecting, by the particle detector, electrons received when the electron beam is not incident on the sample, and for each image pixel, subtracting an amount proportional to the electrons counted for each pixel of the detector from the display value of the corresponding image pixel.

The method may further comprise applying an energy filter to the measured energy values or to the energy-weighted contribution values. For example, the energy filter may be one of a predetermined energy band, one or more electron energy ranges, or a predetermined energy threshold. Applying an energy filter can help reduce the processing demand by discarding unwanted results.

The method may further comprise displaying the generated energy-weighted electron diffraction pattern.

The method may further comprise interpreting the generated energy-weighted electron diffraction pattern to derive one or more structural properties of the sample. The one or more structural properties may comprise crystal orientation, crystal phase, phase composition, texture, and strain location.

In a second aspect, there is an electron diffraction system. The system comprises an electron source configured to provide a beam of electrons to a sample holder, i.e., towards the sample holder. The sample holder is configured to hold a sample. The system further comprises a particle detector configured to detect electrons scattered from the sample, and a processing device communicatively coupled to the particle detector. The processing device is configured to perform all of the method steps as described above.

In a third aspect there is a computer program comprising computer program instructions that, when executed by a computer processing system, cause the computer processing system to perform a method of producing an energy-weighted electron diffraction pattern. The method comprises receiving data comprising measured energy values of detected electrons along with identifiers of pixels that detected the detected electrons, wherein the data was obtained by directing an electron beam to be incident upon a sample. The method further comprises detecting, by a particle detector with an array of pixels, electrons scattered from the sample, wherein the detecting comprises, for each detected electron at a pixel, measuring an energy value that is proportional to the energy of the detected electron. The method further comprises calculating an energy-weighted contribution value from each measured energy value using an energy-dependent function, wherein the energy-dependent function varies with electron energy. The method further comprises generating an energy-weighted electron diffraction pattern using pixel positions associated with each pixel identifier, and the energy-weighted contribution values.

Optionally, the energy-dependent function increases or decreases the contribution of a detected electron to the generated energy-weighted electron diffraction pattern dependent on the energy of that detected electron. The energy-dependent function may increase the contribution of higher-energy detected electrons relative to lower-energy detected electrons. The energy-weighted contribution value may be higher for a detected electron than the energy-weighted contribution values for all detected electrons with a lower energy. The energy-dependent function may produce energy-weighted contribution values that increase with increasing energy values. The energy-dependent function may produce energy-weighted contribution values that increase linearly with increasing energy values. The energy-dependent function may be user settable.

Optionally, the detecting further comprises, for each detected electron, measuring the detection time of the detected electron, and the sending further comprises sending the measured detection time of the detected electron to the processing device.

Optionally, measuring the energy value comprises measuring the time that the charge induced in a pixel struck by an electron is above a detector threshold level.

Optionally, generating the energy-weighted diffraction pattern using the pixel positions and the energy-weighted contribution values comprises generating a diffraction pattern comprising an array of image pixels arranged to conform to the array of pixels of the particle detector, wherein each image pixel is displayed with a display value proportional to a combination of the energy-weighted contribution values of the electrons detected to have struck the corresponding pixel of the particle detector.

Optionally, the energy-dependent electron diffraction pattern is a colour image and the display values are values on a colour gradient or the energy-dependent electron diffraction pattern is a grayscale image and the display values are intensities.

Optionally, the computer program instructions, when executed by the computer processing system, cause the computer processing system to perform a background subtraction by detecting, by the particle detector, electrons received when the electron beam is not incident on the sample, and for each image pixel, subtracting an amount proportional to the electrons counted for each pixel of the detector from the display value of the corresponding image pixel.

Optionally, the computer program instructions, when executed by the computer processing system, cause the computer processing system to apply an energy filter to the measured energy values or to the energy-weighted contribution values. The energy filter may be one of: a predetermined energy band, one or more electron energy ranges, or a predetermined energy threshold.

Optionally, the computer program instructions, when executed by the computer processing system, cause the computer processing system to display the generated energy-dependent electron diffraction pattern.

Optionally, the computer program instructions, when executed by the computer processing system, cause the computer processing system to interpret the generated energy-dependent electron diffraction pattern to derive one or more structural properties of the sample. The one or more structural properties may comprise crystal orientation, crystal phase, phase composition, texture, and strain location.

The computer program may include computer program instructions that when executed by the computer processing system cause the computer processing system to carry out any and all aspects and variations of the method of the first aspect as described above, which are not repeated here for brevity.

In a fourth aspect, there is a computer readable medium having stored thereon the computer program as described above.

### BRIEF DESCRIPTION OF THE DRAWINGS

In order that the invention can be more readily understood, reference will now be made, by way of example only, to the accompanying drawings in which:
Figure 1 illustrates an exemplary electron diffraction system.
Figure 2 illustrates a comparison of a counting mode and a time over threshold (TOT) mode of a particle detector.
Figure 3 illustrates an exemplary electron diffraction method.
Figure 4 illustrates a histogram of measured electron energies in hour cycles.
Figure 5 illustrates the effective contribution to an electron diffraction pattern of energy-weighted contribution values as compared to contribution values that are not energy-weighted.
Figure 6 illustrates an image of an exemplary energy-weighted electron diffraction pattern of a sample generated using the described exemplary systems and methods.
Figure 7 illustrates a comparison of band contrast showing the effect of energy-weighted contribution values as compared to non-weighted contribution values.
Figure 8 illustrates an exemplary offline electron diffraction method.
Figure 9 illustrates an exemplary online electron diffraction method.

### DETAILED DESCRIPTION OF THE INVENTION

### Electron diffraction system

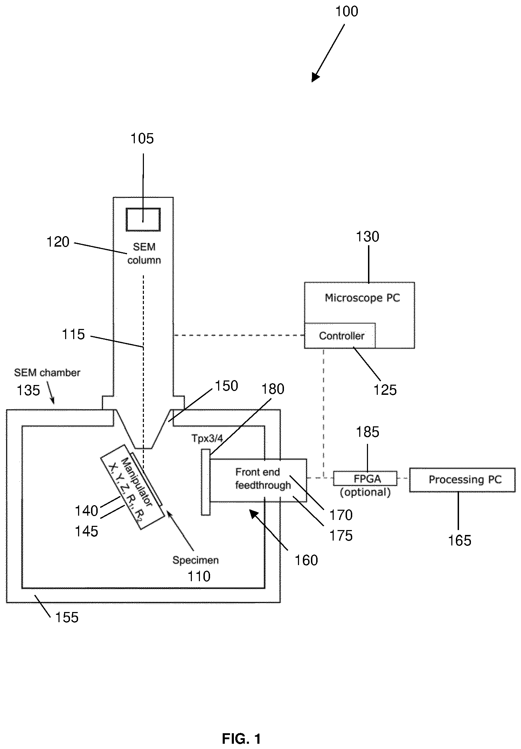

Figure 1 illustrates an exemplary electron diffraction system 100 for generating electron backscatter diffraction (EBSD) patterns that can be used to characterise a sample of interest.

The system 100 comprises an electron beam source 105 that provides a beam of monochromatic, or substantially monochromatic, electrons towards a sample 110, along a beam axis 115. The electrons may have an energy selected from a range of energies, e.g., an energy between 3 - 50 keV. The electron source 105 may be included in an electron beam column 120 as part of a scanning electron microscope (SEM) setup. The electron beam column 120 is configured to adjust the electron beam to focus to a point on the sample 110 and to scan the electron beam over the whole surface of the sample 110, for example line by line or section by section. A controller 125 in communication with the electron beam column 120 controls the movement of the electron beam, and start/stopping of the electron beam. The controller 125 may be part of a SEM computer 130.

A chamber 135, typically a vacuum chamber, houses a sample holder 140. The sample holder 140 may be part of a manipulator 145 that is used to translate and rotate the sample 110 into a desired position and orientation. In this way, the sample 110 may be placed in a selectable angle relative to the beam axis 115, for example, at 70 degrees to the beam axis 115. In other examples, the angle may be between 0 and 80 degrees. The electron beam column 120 is aligned with an aperture 150 in the chamber housing 155 to allow the beam of electrons to pass into the chamber 135 and contact the sample 110.

The system 100 also comprises a particle detector 160 positioned within the chamber 135 that is configured to detect electrons scattered from the sample 110. In other words, the particle detector 160 detects the electrons that have undergone an interaction with the sample 110. As electron diffraction methods and systems are described herein, and as it is electrons that are being detected, the particle detector 160 described herein is an electron detector 160. Data about the scattered electrons are collected by the particle detector 160 and sent to a processing device for processing into diffraction patterns. In this embodiment, the processing device comprises a computer system including a computer 165 and/or a field-programmable gate array 185. In the following description, the processing device is described as comprising the computer 165.

The particle detector 160 comprises a front-end 170 configured process the collected data. The front-end 170 pre-processes the data before sending the data to the computer 165 for further processing. The front-end 170 also provides power to the particle detector 160 and handles cooling, if necessary. The particle detector 160 also comprises a feedthrough 175 through which are routed the communication links that allow the data transfer from the chamber 135 to the computer 165.

The particle detector 160 also includes a particle detector chip 180 that comprises a semiconductor sensor chip (e.g., a silicon chip) bonded to an electronic readout chip. The semiconductor sensor chip includes an array of pixels, e.g., 256 x 256 pixels or 512 x 448 pixels. Examples of such particle detector chips 180 include the Timepix3 (see https://kt.cern/technologies/timepix3) and the Timepix4 (see https://indico.cern.ch/event/591299/contributions/2423187/attachments/1393307/2123191/ Timepix4_specs.pdf and https://cds.cern.ch/record/2825271), which are available from ADVACAM (https://advacam.com/), ASI (https://www.amscins.com/index.html), and Quantum Detectors (https://quantumdetectors.com/).

Conventional particle detectors operate in a 'counting' mode that counts each electron incident on the pixels as 1. In most detectors, the counting mode is frame-based, i.e., the counts for each of the pixels are collected in a predefined time interval, a frame, and the count for each pixel is read out at the end of the frame. Thus, the readout from each pixel describes how many electrons were counted in the timeframe over which the readout was collected.

Timepix3 and Timepix4 particle detectors 160 can also operate in a data driven mode. In the data driven mode, information about the detected electrons is readout for each detected electron as and when the particle detector 160 detects the electron striking a pixel, rather than accumulating a total count for each pixel to be readout at the end of a frame.

When operating in the data driven mode, these particle detectors 160 can measure the electron energy deposited in each pixel by each incident electron. As the electron strikes the pixel, the particle detector 160 measures a value that is proportional to the energy of the incident electron. This measured energy value is also called the 'time over threshold' (TOT) value, E. Particle detectors 160 measuring this time over threshold value are operating in a 'time over threshold' mode. The threshold may be used to discriminate electrons according to their energy, i.e., such that electrons with an energy below the threshold are not counted. Both the instance of the electron detection and this measured value are read out from the pixel and used in subsequent processing.

In more detail, an electron striking a pixel causes a cascade of electron-hole pairs. The number of electron-hole pairs is proportional to the energy given up by the electron, and a charge is imparted to the pixel that is proportional to the number of electron-hole pairs. The time taken for the pixel to discharge back to the detector threshold level after an electron strike is the time over threshold value, and is proportional to the charge imparted to the pixel. Hence, this time is also proportional to the energy of the detected electron measured by the particle detector 160 (i.e., the actual electron energy is the time over threshold value multiplied by a coefficient). Said another way, this measured time over threshold value is the time that the signal outputted from the particle detector 160 is above the detector threshold level, or the number of hour cycles (internal clock time) that the charge of the pixel remains above the detector threshold level. The detector threshold level is adjustable and may be set before use and altered during use to provide the desired level of electron energy discrimination.

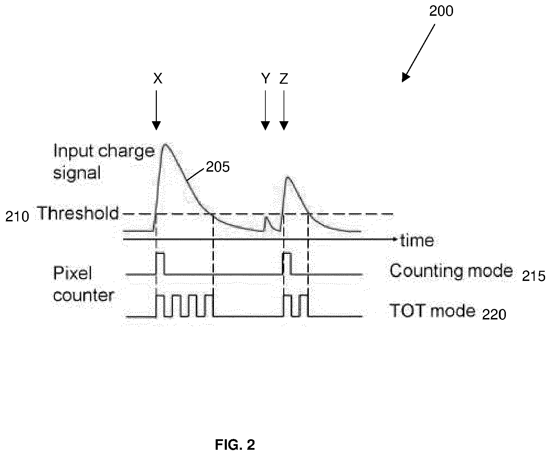

Figure 2 illustrates a comparison 200 of the counting mode and the time over threshold mode of a particle detector. The top graph displays the charge accumulated in a pixel against time. The descending curved line 205 is the charge signal recorded by the particle detector during the gradual discharge of the pixel over time relative to a detector threshold level 210.

The middle graph displays the counting mode 215. When an electron strikes a pixel with an energy sufficient to cause the pixel to charge to above the detector threshold level 210, one count is measured by a pixel counter in the particle detector 160, as shown at points X and Z. When an electron strikes a pixel with an energy insufficient to cause the pixel to charge to above the detector threshold level 210, as shown at point Y, no count is measured by the pixel counter.

The bottom graph displays the count for the time over threshold mode 220. When an electron with an energy above the detector threshold level 210 strikes a pixel, the pixel counter counts the number of hour cycles the pixel charge remains above the detector threshold level 210. This is the measured time over threshold value *E* mentioned above. The event at X is a higher energy electron strike which leads to a longer discharge time and a time over threshold value *E* of 4. The event at Z is a lower energy electron strike which leads to a shorter discharge time and a time over threshold value *E of* 2. The event at Y is below the detector threshold level 210 and so has a zero time over threshold value.

At the same time as measuring this time over threshold value *E,* the particle detector 160 may also measure the detection time of the detected electron, for example the time of arrival, *t*, of the detected electron, i.e., the timestamp of when the electron struck the pixel. These measured data can be included in a vector *(x, t, E)* for each detected electron that also includes the pixel position *x* of the pixel that detected the electron.

The measured data for each detected electron are sent from the particle detector 160 to the computer 165 for processing. The position of the pixel for each detected electron may be sent, or an identifier of the pixel may be sent from which the position may be determined in a subsequent processing step. These data are sent after each and every electron strike because the particle detector 160 is operating in the data driven mode, i.e., information about each and every detected electron, such as the vector *(x, t, E),* is provided in real time to the computer 165. This is in contrast to the counting mode, where information is only sent as a full frame read-out after a set measurement time.

The computer 165 is in communication with the particle detector 160 via the feedthrough 175 and receives the collected electron data for processing to generate electron diffraction patterns. The computer 165 comprises a processor and memory for storing computer readable instructions. The computer 165 may be any suitable computer configured to operate software for generating electron diffraction patterns. Optionally, the field-programmable gate array (FPGA) 185 may be in communication with the particle detector 160 and computer 165 for processing the received signal. In some examples, the computer 165 is configured to carry out the below-mentioned method steps. In other examples, the FPGA 185 is configured to carry out the method steps. The controller 125 may also be in communication with the computer 165 and/or FPGA 185 so as to control the processing. The computer 165 may be a separate computer to the SEM computer 130 or may be part of the SEM computer 130.

### Electron diffraction method

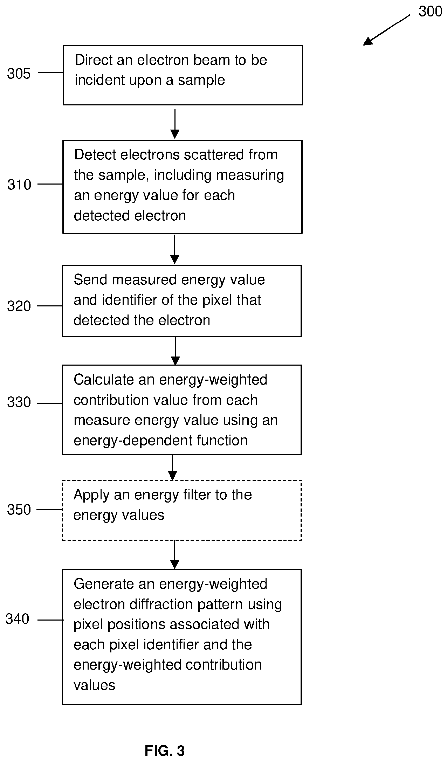

Figure 3 illustrates an exemplary electron diffraction method 300 that can be carried out using the system 100 described above and as shown in figure 1. The method 300 may also be carried out using other suitable electron diffraction setups that comprise a time over threshold mode particle detector 160 as described previously.

Experimental diffraction conditions may be set first. For example, the sample of interest 110 is loaded into the sample holder 140 in the chamber 135 and set into the desired position and orientation by the manipulator 145. The electron beam column 120 is configured to move the electron beam into position under control of the controller 125 so as to align the electron beam and the sample 110 at a fixed angle. Other setup conditions may also be selected, e.g., electron beam voltage, electron beam current, sample-detector distance, map dimension and acquisition times, and applied.

The controller 125 initiates the electron beam and the electron beam is directed 305 to be incident upon the sample 110. The controller 125 initiates data collection and synchronises the data collected with the beam scanning in order to know the location of the electron beam on the sample 110 for each scattered electron that is detected. In more detail, as the times of data acquisition and the positions of the beam are known, the measured time of arrival, *t*, values can be used to determine which electrons were scattered from which region of the sample 110. This can be done either through one pass (i.e., one picture is taken) or through several (multiple pictures are taken, and second picture is added to the first picture, and so on).

The electron beam is targeted at a first region of interest of the sample 110. For example, the surface of the sample 110 may be split into a grid of sections, with each region of interest being one or more sections of the grid. As the electron beam contacts the first region of the sample 110, some electrons from the beam are scattered towards the particle detector 160 at varying angles. Scattered electrons strike the pixels of the particle detector 160 and the particle detector 160 measures 310 the energy E of each detected electron (where E is the time over threshold value that is proportional to the electron's energy). The particle detector 160 may also measure the time of arrival *t* of each detected electron. In response to each detected electron, these data about the detected electron are transferred 320 to the computer 165 for processing, e.g., as the vector *(x, t, E)* that also contains the pixel position *x* for each detected electron and sent for processing. The particle detector 160 continues to transfer the detected electron data to the computer 165 as each electron is detected in a continuous manner (the particle detector 160 is operating in the data driven mode). This is in contrast to the counting mode, where data are sent as a full frame read-out and, as such, the total data acquisition time is not limited by the frame readout time in the data driven mode.

After scanning the first region for a set time period, e.g., 0.5ms, the electron beam is moved by the controller 125 to a second region of interest of the sample 110 and the data are collected while the electron beam is scanned over the second region, and so on until all of, or at least a part of, the sample 110 has been scanned.

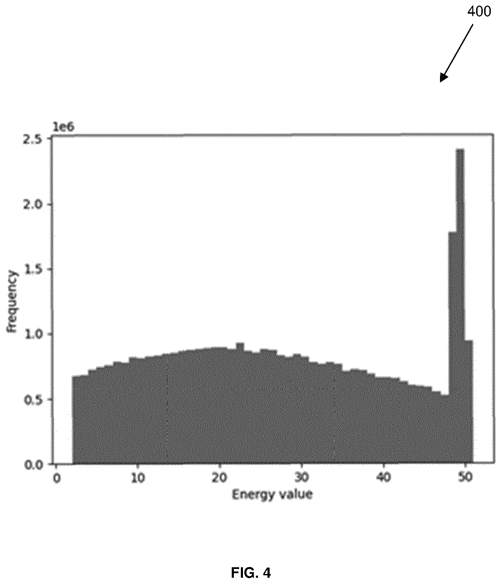

Often, in electron diffraction, the higher energy electrons are the most useful electrons because they provide the most information about the sample 110. A histogram of an exemplary electron energy spectrum 400, illustrating the variation in the possible energies of electrons, is shown in figure 4. It is desirable to increase the contribution of the high energy electrons when generating electron diffraction patterns. Conventional diffraction methods can apply an energy filter to discard electrons below a set threshold energy. However, as such methods operate in the counting mode, the conventional particle detectors are only able to distinguish the number of electrons counted above the threshold. There is no way to know by how much or how little the energy of each electron counted is above this threshold, nor how much influence each electron has on the diffraction pattern.

It is important to be able to include lower energy electrons in the diffraction patterns because they contain information about the sample 110 and the background signal detected by the particle detector 160. To distinguish between high and low energy electrons better, the detected electron's energy can be used as a discrimination parameter to produce energy-weighted diffraction patterns. As shown at step 330 of figure 3, a weighting is obtained by using the measured energy/time over threshold values, E, of the measured electron data collected in the time over threshold mode by the particle detector 160, or values derived from the measured energy/time over threshold values. This is in contrast to the conventional technique where each electron is merely counted as the same value (a count of 1). This weighting comprises using the measured energy values or a value that is dependent upon the measure energy values, for example a scaled value. In all cases, the values used when generating the electron diffraction pattern are referred to herein as energy-weighted contribution values that are calculated using an energy-dependent function. Where the measured energy values are used directly as the energy-weighted contribution values, the energy-dependent function effectively becomes a multiplication of the measured energy values by unity. Using the calculated energy-weighted contribution values results in the detected electrons each having a weight-based contribution to a generated diffraction pattern 340, wherein the contribution is dependent on the detected electron's energy.

Weighting correlates the measured energy/time over threshold value with the actual energy of each detected electron (where high energy electrons are considered to be more important because they carry most of the information). By assigning weight (and thus importance) to each individual electron detected, the discernibility of the diffraction pattern is improved. Weighting the data increases the amount of information that can be extracted from the diffraction patterns, for example because it increases the ratio of useful signal to background and provides better contrast in the diffraction patterns as compared to conventional electron counting.

Using the energy-weighted contribution values gives some of the measured energy/time over threshold values more weight (or influence) on the generated electron patterns compared to other values, and as such, reflects the contribution of electron energy to the diffraction pattern. The energy-dependent function may alter the nature of this energy dependence on the contribution of each electron to the electron diffraction pattern. For example, the energy-dependent function may exaggerate the contribution of higher energy electrons to increase further their contribution to the diffraction pattern, and reduce the contribution of lower energy electrons.

The energy-dependent function can be any suitable function that increases or decreases the contribution of detected electrons according to their energies. For example, the energy-dependent function may be proportional or inversely proportional to electron energy. The energy-dependent function may be linear or non-linear such as exponential, sinusoidal etc. The energy-dependent function can be user selectable. Any suitable function, or plurality of functions, can be chosen by the user for application to the particle detector data.

In one example, the energy-dependent function is F(*E*) = 0.5*E*², where *E* is the measured energy values (e.g., in keV) collected by the particle detector 160 operating in the time over threshold mode. In another example, the energy-dependent function is F(*E*) = *2E-* 10. The energy-dependent function may be of the form F(*E*) = 2*E -* 20 so as to favour electrons above 10 keV and discriminate electrons below 10 keV (for a 20 keV beam).

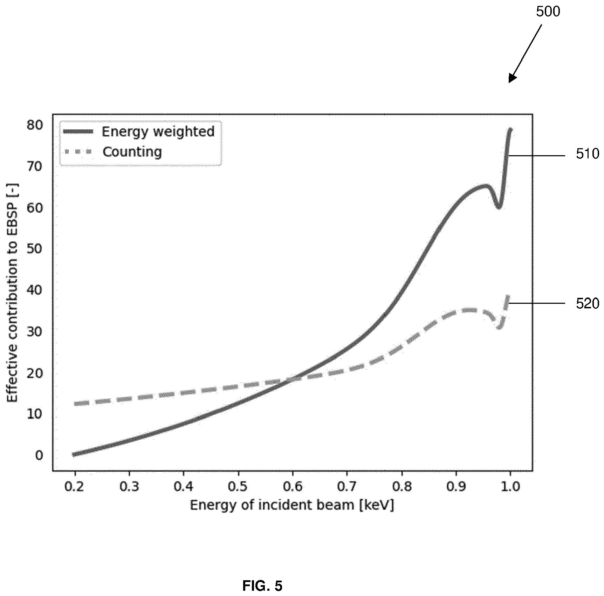

The effect of using energy-weighted contribution values is shown in figure 5. Figure 5 illustrates the effective contribution 500 to an electron diffraction pattern of using energy-weighted contribution values that increase with electron energies 510 (solid line) as compared to contributions that do not vary with electron energies 520 (dashed line). The x-axis shows the energy of the scattered electrons expressed as a fraction of the electron beam energy. The y-axis shows the electron's effective contribution to the generated electron diffraction pattern. As can be seen in figure 5, using energy-weighted contribution values (solid line) increases the effective contribution based on the electron's energy, so higher-energy electrons contribute more to the generated electron diffraction pattern than lower-energy electrons. As described previously, in the time over threshold mode, the particle detector 160 measures the time over threshold value, E, for each detected electron. As this time is dependent on the electron's energy (i.e., the pixel takes longer to discharge for a more energetic electron because the electron deposits more charge (electron-hole pairs) in the pixel on impact), this measured time represents a value proportional to the electron's actual energy.

An electron diffraction pattern may now be generated 340 as follows. After the detected electron data has been collected and the energy-weighted contribution values calculated, a matrix the same size as the pixel array of the particle detector 160 is created, e.g., a 256 x 256 matrix. Each pixel position *x* is mapped to the corresponding matrix element position such that the matrix is representative of where each electron was detected in the pixel array of the particle detector 160, e.g., pixel position *x_{i,j}* is mapped to the position of matrix element *M_{i,j}* in the matrix. Each energy-weighted contribution value is added to the appropriate matrix element based on the pixel position at which the electron was detected, e.g., the energy-weighted contribution value calculated for a pixel position *x_{i,j}* is added to matrix element *M_{i,j}.* Adding each of the energy-weighted contribution values associated with a pixel provides a cumulative total of the energy-weighted contribution values of all the electrons that were detected by any particular pixel of the particle detector 160. The energy-weighted contribution value takes each individual electron's energy into account, so the electrons contribute a varying count, e.g. 0.5, 3, 0.1 etc, to their corresponding matrix elements, depending on their measured energy E (and the form of the energy-dependent function F(E)). This increases the importance of a certain part(s) of the electron energy spectrum.

In conventional counting mode, each incoming electron always contributes a value of 1 count to the corresponding matrix element. Hence, an electron diffraction pattern is formed by simply summing each of these single counts. In contrast, the method described herein abandons the use of summing single counts. Instead a summation of contribution values from each electron strike is made. Moreover, these contribution values are energy-weighted contribution values whose values vary with the energy of the electrons, with that variation determined by the energy-dependent function. Using energy-weighted contribution values in this way means that a matrix element of a pixel seeing several low-energy electron strikes may hold a lower cumulative value than a matrix element of a pixel seeing only a single high-energy electron strike.

As described above, the energy-weighted contribution values are calculated before populating the matrix with the energy-weighted contribution values. In other examples, the energy-weighted contribution values may be calculated (in the same way) after the matrix has been populated with the measured energy values E.

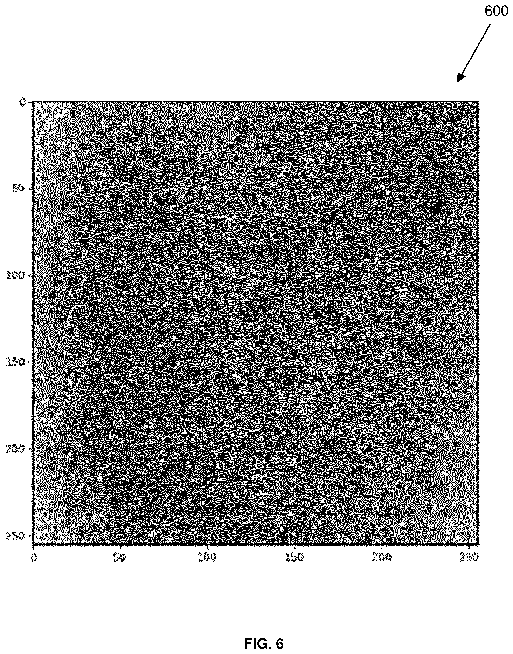

The matrix forms the energy-weighted electron diffraction pattern in its raw state. Each element of this matrix can be mapped to a display value, e.g., a value in a colour gradient or an intensity in a greyscale. An image can then be produced from these display values to illustrate the energy-weighted electron diffraction pattern as a colour/greyscale map. An example of such an energy-weighted electron diffraction pattern is shown in figure 6. The generated energy-weighted electron diffraction pattern may then be interpreted to derive one or more structural properties of the sample 110 as described in more detail below. For example, the sample's crystal lattice and orientation in space can be derived from the generated electron pattern. From this information, and the comparison of diffraction patterns taken across the surface of the sample 110 (i.e., multiple regions of interest/sections of the surface), further properties of the sample 110 can be determined.

Further processing may be performed to improve the quality of the energy-weighted electron diffraction pattern still further.

For example, the data collected by the particle detector 160 include a background signal which can affect the quality of the energy-weighted electron diffraction pattern. The background signal corresponds to a "dark" signal generated by the particle detector 160 when there is no electron beam incident on the sample 110. Hence, the background can be found from data read out from the particle detector 160 prior to the actual data measurements taken with the electron beam incident on the sample 110. This background signal can be subtracted/divided from each new generated electron diffraction pattern.

Other ways of improving the quality of the pattern still further include outlier elimination and contrast stretching. For example, to eliminate outliers, an algorithm searches for matrix element values that are much higher or much lower than the median value and replaces them with the median value. In contrast stretching, the lowest and highest matrix element values are found, and then all of the values are transformed (i.e., stretched) to a larger range of available display values, thus improving contrast, e.g., improving contrast in the colour/greyscale image shown in figure 6.

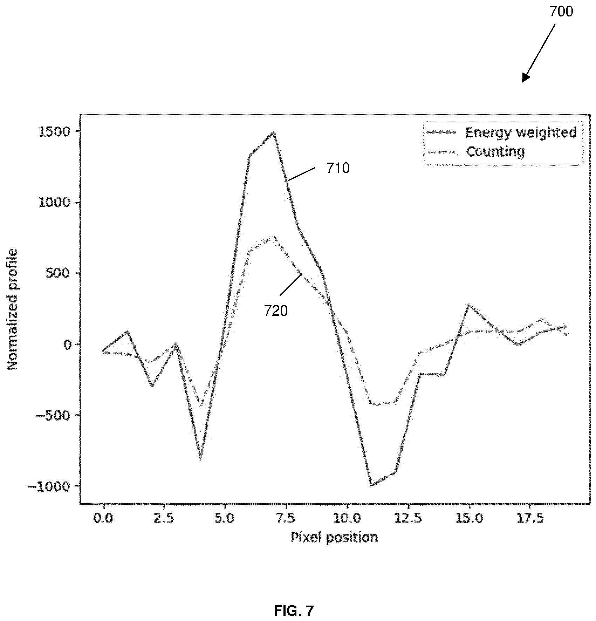

The generated image (e.g., see figure 6) shows the Kikuchi bands that are characteristic of a specific sample, and they provide information about the sample's structure and orientation. Figure 7 illustrates a band profile height 700 of two flat-fielded patterns taken from the same sample grain. This shows a comparison of band contrast and demonstrates the effect of using energy-weighted contribution values as compared to merely counting electron strikes. The solid line 710 is the band profile acquired when each detected electron has been weighted dependent on its energy. The dashed line 720 is the band profile when each detected electron has no weighting. By assigning weight and thus importance to each individual electron, it is possible to increase contrast of the bands and thus visibility. This in turn increases the confidence in solving diffraction patterns using an indexing algorithm, and produces more precise results. The higher the contrast in the bands, the more visible they are to the indexing algorithm, and so the band peaks may be determined with greater precision. This allows energy-weighted patterns to be acquired in less time than non-weighted patterns. For example, using the above described method, it is possible to index an energy-weighted electron diffraction pattern after collecting data for 0.7 ms, whereas using a non-weighted pattern would need longer, e.g., data collection over 1 ms or more, to produce the same indexing success/confidence.

To help interpret the energy-weighted electron diffraction patterns, a Hough transform can be applied to help identify the bands. The bands form bright peaks (i.e., highest intensity peaks) in the Hough space. These minimum/maximums can be seen in figure 7 and are the points looked for in the Hough space. Other standard processing methods may also be used to identify the bands. As described earlier, the electron beam is moved across sample regions of interest, e.g., to cover a grid, section by section, of the sample surface. At each region of interest, measured data are collected, weighted and used to generate an energy-weighted electron diffraction pattern.

Hundreds up to hundreds of thousands of these patterns are generated and subsequently indexed to provide information about structural properties of the sample 110. For example, the patterns can be interpreted to provide information about the crystal orientation (usually expressed by Euler angles), the crystal phase (e.g., whether the crystal phase in a certain pixel is cubic, hexagonal, orthorhombic etc), and the quality of the pattern (which is proportional to the surface quality or deformation of the sample). From such information, it is then possible to compute phase composition (e.g., percentage of cubic phase, percentage of hexagonal phase etc), texture (the size of the average grain, how is the average grain oriented towards a particular axis etc), and the orientation relationship between neighbouring phases, and strain location (e.g., determining sample deformation based on the misorientation of the neighbouring patterns).

Optionally, an energy filter can be applied 350 to the measured data before or after weighting 330 to select one or more energy ranges of interest, for example electrons from 10 - 15 keV, or a set threshold, for example only electrons over 10 keV. Energy bands can also be selected using the energy filter. More specifically, when implemented, the energy filter is applied to the measure time over threshold values, E, of the detected electrons. Additionally, a positional filter may also be applied to the pixel position *x* of the detected electrons. For example, to exclude data from pixels located at or near the edge of the pixel array of the particle detector 160.

In some examples, the energy range of interest is not known. As such, an initial experiment can be run to determine an initial electron diffraction pattern. Subsequent experiments can then be run with selected weighting and filtering dependent on the initial diffraction pattern to produce improved diffraction pattern results. The energy filter may be applied at the particle detector 160 if the energy range of interest is already known (for example when the sample is a known material). Therefore, unwanted electrons are discarded before weighting, which saves space and increases the processing speed. Alternatively, the energy filter may be applied after the weighting, for example in cases where the sample material is unknown. When carrying out the electron diffraction method 300 as described above, the weighting may be applied at different points. This is useful in cases where it is not clear initially what electron energies should be studied. An initial experiment can be run, and the energy range narrowed down to a region of the energy spectrum of interest in subsequent experiments. For example, in cases where the energy-dependent function is not yet known (e.g., in an initial experiment), the energy-dependent function is applied after the measured detector data has been saved, i.e., offline. In cases where the energy-dependent function is already known (e.g., in a subsequent experiment which has produced data giving an idea of the type of energy-dependent function to apply), the energy-dependent function can be applied after the measured detector data leave the particle detector 160 or at the FPGA 185, or the energy-dependent function can be applied while the data are being saved or processed by the computer 165, i.e., online.

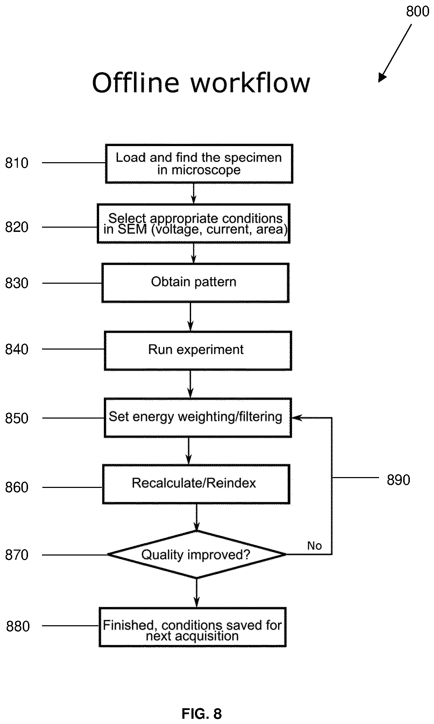

Figure 8 illustrates an exemplary offline version 800 of the electron diffraction method described previously. The sample is loaded into the sample holder and aligned with the electron beam column 810. Experimental conditions, such as electron beam voltage, electron beam current, area or region of interest etc, are set and initial data acquisition begins 820. The particle detector 160 records detected electron data and generates an initial electron diffraction pattern 830 (that isn't weighted). This initial pattern is reviewed for quality, and if it is not of suitable quality, the experimental conditions are updated and the initial pattern is regenerated. Once of satisfactory quality, the system begins acquiring detected electron data for characterising the sample 840. The energy-dependent function is applied to the detected electron data 850. An energy filter may also be applied at this point. The detected electron data are reprocessed, with the weighting included, to generate a subsequent energy-weighted electron diffraction pattern 860. The energy-weighted electron diffraction pattern is checked for quality 870. If the quality has improved due to the weighting, the method ends and the experimental conditions are saved for future acquisitions 880. If the quality has not improved, the energy-dependent function is adjusted (and optionally the filtering may be adjusted too) and reapplied to the detected electron data 890. The detected electron data are reprocessed again, with the adjusted weighting included, to generate an updated energy-weighted electron diffraction pattern. This loop may be repeated until an appropriate improvement in the energy-weighted electron diffraction pattern is seen.

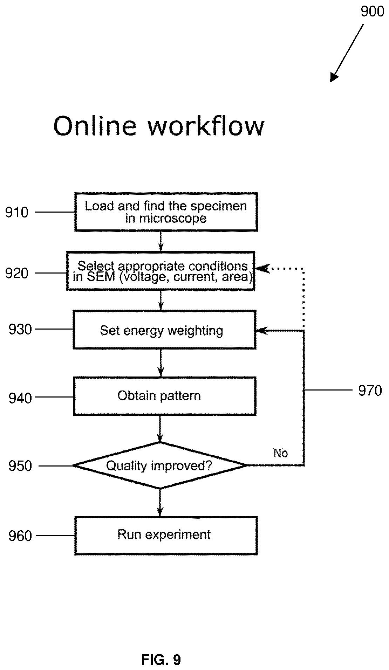

Figure 9 illustrates an exemplary online version 900 of the electron diffraction method described previously. Similar to the offline method of figure 8, the sample is loaded into the sample holder and aligned with the electron beam column 910. Experimental conditions, such as electron beam voltage, electron beam current, area or region of interest etc, are set and data acquisition begins 920. The particle detector 160 records detected electron data and the energy-dependent function is applied as the data are being saved to the computer 930 (an energy filter may also be applied). The weighted electron data are processed to generate an energy-weighted electron diffraction pattern 940 and checked for quality 950. If the quality has improved due to the weighting, the system begins acquiring detected electron data for characterising the sample 960. If the quality has not improved, the energy-dependent function is adjusted (and optionally the filtering may be adjusted too) and reapplied to the detected electron data 970. The updated weighted electron data are processed to generate an updated energy-weighted electron diffraction pattern that is checked for quality again. This loop may be repeated until an appropriate improvement in the diffraction pattern is seen. Optionally, the experimental conditions are also updated based on the quality check. As described above, an advantage of weighting the collected data is to increase the contrast in the diffraction patterns. Another advantage of weighting the data is the reduction in the amount of data to be transferred from the particle detector 160. As each electron strike is stored separately when the particle detector 160 is operating in the data-driven mode, it is possible to discard some entries (so they do not have to be saved). Thus, less data can be saved without compromising the quality of the results.

The energy-weighted electron diffraction patterns described here have a variety of uses including, but not limited to, scanning electron microscopy (SEM), transmission electron microscopy (TEM), scanning transmission electron microscopy (STEM), 4D STEM, transmission Kikuchi diffraction (TKD), and pixelated STEM in SEM or TEM. The inclusion of electron energy provides an additional dimension for collecting and analysing information. The energy-weighted electron diffraction patterns provide better contrast compared to simple electron counting, increasing the amount of information that can extracted about a sample. The indexation success of electron backscatter diffraction pattern indexers at low illuminations can be increased by assigning more weight to the more energetic electrons. This provides the same spot patterns but with information about energy and time of arrival of each electron. This can also be explored to produce energy-resolved virtual dark-field imaging which would carry depth or thickness information (as electrons passing through more or heavier material are slowed down more). The weighting also enables differentiation of 2D material sheets (i.e. graphene) based on intensity and energy of acquired electrons. Furthermore, as the data are sent immediately, the diffraction patterns are continuously improved after each scan. The time of arrival, *t,* of electrons can be used in SEM stroboscopy.

Whilst a SEM system setup is described, the electron diffraction system may instead be another suitable type of system, such as transmission electron microscopy (TEM) or scanning transmission electron microscopy (STEM) systems.

The above description describes applying an energy-dependent function to the measured energy/time over threshold values, *E.* In additional/alternative examples, an energy-dependent function may be applied to the pixel position values, x. For example, it may be desirable to only include measurements from the middle pixels. As such, a positional function may be applied to increase the contribution of the middle pixels as compared to edge pixels. Alternatively, the band detection algorithm may be adjusted to look for bands in specific areas of the pattern.

The above description discusses the importance of higher energy electrons in electron diffraction methods. However, in other examples, lower energy electrons may be of more interest, and so the energy-dependent function can be selected to increase the influence of lower energy electrons and discriminate against high energy electrons.

## Claims

1. A method of producing an energy-weighted electron diffraction pattern comprising:
directing an electron beam to be incident upon a sample;
detecting, by a particle detector with an array of pixels, electrons scattered from the sample, wherein the detecting comprises, for each detected electron at a pixel, measuring an energy value that is proportional to the energy of the detected electron;
sending the measured energy value of each detected electron and an identifier of the pixel that detected the electron to a processing device;
calculating, by the processing device, an energy-weighted contribution value from each measured energy value using an energy-dependent function, wherein the energy-dependent function produces energy-weighted contribution values that vary with electron energy; and
generating, by the processing device, an energy-weighted electron diffraction pattern using pixel positions associated with each pixel identifier, and the energy-weighted contribution values.

2. The method of claim 1, wherein the energy-dependent function increases or decreases the contribution of a detected electron to the generated energy-weighted electron diffraction pattern dependent on the energy of that detected electron.

3. The method of claim 2, wherein the energy-dependent function increases the contribution of higher-energy detected electrons relative to lower-energy detected electrons such that, optionally, the energy-weighted contribution value is higher for a detected electron than the energy-weighted contribution values for all detected electrons with a lower energy.

4. The method of any preceding claim, wherein the energy-dependent function produces energy-weighted contribution values that increase with increasing energy values such that, optionally, the energy-dependent function produces energy-weighted contribution values that increase linearly with increasing electron energy values.

5. The method of any preceding claim, wherein the energy-dependent function is user settable.

6. The method of any preceding claim, wherein the detecting further comprises, for each detected electron, measuring the detection time of the detected electron, and wherein the sending further comprises sending the measured detection time of the detected electron to the processing device.

7. The method of any preceding claim, wherein measuring the energy value comprises measuring the time that the charge induced in a pixel struck by an electron is above a detector threshold level.

8. The method of any preceding claim, where generating the energy-weighted electron diffraction pattern using the pixel positions and the energy-weighted contribution values comprises:
generating an energy-weighted electron diffraction pattern comprising an array of image pixels arranged to conform to the array of pixels of the particle detector, wherein each image pixel is displayed with a display value proportional to a combination of the energy-weighted contribution values of the electrons detected to have struck the corresponding pixel of the particle detector.

9. The method of claim 8, wherein:
the energy-weighted electron diffraction pattern is a colour image and the display values are values on a colour gradient; or
the energy-weighted electron diffraction pattern is a grayscale image and the display values are intensities.

10. The method of claim 8 or 9, further comprising performing a background subtraction by:
detecting, by the particle detector, electrons received when the electron beam is not incident on the sample; and
for each image pixel, subtracting an amount proportional to the electrons counted for each pixel of the detector from the display value of the corresponding image pixel.

11. The method of any preceding claim, further comprising applying an energy filter to the measured energy values or to the energy-weighted contribution values and, optionally, the energy filter is one of: a predetermined energy band, one or more electron energy ranges, or a predetermined energy threshold.

12. The method of any preceding claim, further comprising displaying the generated energy-weighted electron diffraction pattern.

13. The method of any preceding claim, further comprising interpreting the generated energy-weighted electron diffraction pattern to derive one or more structural properties of the sample and wherein, optionally, the one or more structural properties comprise: crystal orientation, crystal phase, phase composition, texture, and strain location.

14. An electron diffraction system comprising:
an electron source configured to provide a beam of electrons to a sample holder, the sample holder configured to hold a sample;
a particle detector configured to detect electrons diffracted from the sample; and
a processing device communicatively coupled to the particle detector, wherein the processing device is configured to perform the method of any preceding claim.

15. A computer program comprising computer program instructions that, when executed by a computer processing system, cause the computer processing system to perform a method of producing an energy-weighted electron diffraction pattern comprising:
receiving data comprising measured energy values of detected electrons along with identifiers of pixels that detected the detected electrons, wherein the data was obtained by directing an electron beam to be incident upon a sample, and detecting, by a particle detector with an array of pixels, electrons scattered from the sample, wherein the detecting comprises, for each detected electron at a pixel, measuring an energy value that is proportional to the energy of the detected electron;
calculating an energy-weighted contribution value from each measured energy value using an energy-dependent function, wherein the energy-dependent function produces energy-dependent contribution values that vary with electron energy; and
generating an electron diffraction pattern using pixel positions associated with each pixel identifier, and the energy-weighted contribution values; or
a computer readable medium having stored thereon such a computer program.
